# EUROPEAN PATENT APPLICATION

(11) **EP 4 811 957 A1**
(43) Date of publication of application: **23.09.2026**
(21) Application number: 26151810.4
(22) Date of filing: 14.01.2026
(51) Int. Cl.: H10D 30/66, H10D 30/01, H10D 62/10, H10D 64/01, H10D 64/62, H10D 62/13

(54) **SEMICONDUCTOR STRUCTURE AND MANUFACTURING METHOD THEREOF**

(30) Priority: 19.03.2025 CN 202510326539
(71) Applicant: Diodes Incorporated, Plano, Texas 75024 (US)
(72) Inventor: KUO, Ta-Chuan, 231023 New Taipei City (TW); CHUANG, Chiao-Shun, 231023 New Taipei City (TW)
(74) Representative: Marks & Clerk LLP

(57) **Abstract**

A semiconductor structure includes an epitaxial layer on a substrate, a first lightly doped layer on the epitaxial layer, a second lightly doped layer on the first lightly doped layer, a heavily doped layer on the first lightly doped layer, a metal silicide layer on the second lightly doped layer and the heavily doped layer, and a gate structure, which extends from a top surface of the metal silicide layer toward the substrate, through the second lightly doped layer, the heavily doped layer and the first lightly doped layer, and into the epitaxial layer. A doping concentration of the second lightly doped layer at an interface between the second lightly doped layer and the metal silicide layer is less than a doping concentration of the heavily doped layer and greater than a doping concentration of the first lightly doped layer. A method of manufacturing the semiconductor structure is also provided.

## Description

### CROSS-REFERENCE TO RELATED APPLICATIONS

This patent application claims priority to China Patent Application No. 202510326539.4, filed on March 19, 2025 and entitled "SEMICONDUCTOR STRUCTURE AND MANUFACTURING METHOD THEREOF," which is hereby incorporated by reference herein as if reproduced in its entirety.

### TECHNICAL FIELD

The present disclosure relates generally to the field of semiconductors, and in particular embodiments, to techniques and mechanisms for a semiconductor structure and a method for manufacturing the semiconductor structure. In some embodiments, a semiconductor structure with a small spacing gate structure and a manufacturing method for the same are provided.

### BACKGROUND

As the size of semiconductor structures shrinks, the distance between components is greatly reduced, resulting in many parasitic components. These parasitic components may degrade the electrical properties of the semiconductor structures or affect the functions of the semiconductor structures. Therefore, how to avoid generation of parasitic components has become an important consideration in the art.

### SUMMARY

Embodiments of the present disclosure relate to a semiconductor structure. The semiconductor structure includes a substrate, an epitaxial layer on the substrate, a first lightly doped layer on the epitaxial layer, a second lightly doped layer over the epitaxial layer, a metal silicide layer over the second lightly doped layer, a gate structure, a heavily doped layer, and a metal layer. The gate structure extends from the top surface of the metal silicide layer toward the substrate into the epitaxial layer. The heavily doped layer is disposed on the first lightly doped layer and is surrounded by the second lightly doped layer. The metal layer covers the top surface of the metal silicide layer. The metal silicide layer covers and contacts the top surface of the second lightly doped layer and the top surface of the heavily doped layer. The doping concentration of the second lightly doped layer at the interface between the second lightly doped layer and the metal silicide layer is less than the doping concentration of the heavily doped layer and greater than the doping concentration of the first lightly doped layer.

Optionally, in the preceding embodiment, the heavily doped layer is disposed between the first lightly doped layer and the metal silicide layer, and adjoins the second lightly doped layer, and wherein in a top view, the heavily doped layer and the second lightly doped layer do not overlap.

Optionally, in any of the preceding applicable embodiments, the top surface of the second lightly doped layer is coplanar with the top surface of the heavily doped layer.

Optionally, in any of the preceding applicable embodiments, the second lightly doped layer and the heavily doped layer have different thicknesses.

Optionally, in any of the preceding applicable embodiments, a thickness of the second lightly doped layer is smaller than a thickness of the heavily doped layer.

Optionally, in any of the preceding applicable embodiments, the first lightly doped layer and the heavily doped layer have a P-type conductivity, and the epitaxial layer and the second lightly doped layer have a N- type conductivity.

Optionally, in any of the preceding applicable embodiments, at an interface between the second lightly doped layer and the metal silicide layer, a doping concentration of the second lightly doped layer is less than 1E+18 cm⁻³.

Optionally, in any of the preceding applicable embodiments, the doping concentration of the second lightly doped layer at the interface between the second lightly doped layer and the metal silicide layer is greater than a doping concentration of the second lightly doped layer at an interface between the second lightly doped layer and the first lightly doped layer.

Optionally, in any of the preceding applicable embodiments, the second lightly doped layer, the heavily doped layer, the metal silicide layer and the metal layer are all electrically connected to a source to serve as a source structure.

Optionally, in any of the preceding applicable embodiments, the gate structure may comprise: an electrode layer; an isolation layer, disposed on the electrode layer; and a dielectric oxide layer surrounding the electrode layer and the isolation layer, wherein a top surface of the isolation layer, a top surface of the dielectric oxide layer and a top surface of the metal silicide layer are coplanar.

Optionally, in any of the preceding applicable embodiments, a bottom surface of the second lightly doped layer is closer to the substrate than a bottom surface of the isolation layer.

Optionally, in any of the preceding applicable embodiments, a thickness of the second lightly doped layer is smaller than a thickness of the metal silicide layer.

Optionally, in any of the preceding applicable embodiments, the thickness of the metal silicide layer is greater than or equal to 0.1 um.

Optionally, in any of the preceding applicable embodiments, the metal silicide layer comprises cobalt silicide, nickel silicide, titanium silicide, platinum silicide, or a combination thereof.

Optionally, in any of the preceding applicable embodiments, the gate structure comprises: an electrode layer; an isolation layer, disposed on the electrode layer; a source layer, disposed below the electrode layer; and a dielectric oxide layer surrounding the electrode layer, the source layer and the isolation layer and extending between the electrode layer and the source layer, wherein a top surface of the isolation layer, a top surface of the dielectric oxide layer and a top surface of the metal silicide are coplanar.

Optionally, in any of the preceding applicable embodiments, ohmic contacts are formed between the metal silicide layer and the second lightly doped layer and between the metal silicide layer and the heavily doped layer, respectively.

Optionally, in any of the preceding applicable embodiments, the semiconductor structure may further comprise an additional metal layer disposed between the metal layer and the metal silicide layer, the additional metal layer comprising titanium, aluminum and copper. Embodiments of the present disclosure relate to a method for manufacturing a semiconductor structure. The method comprises: providing a substrate, wherein the substrate has an epitaxial layer on the substrate; disposing a gate structure in the epitaxial layer; forming a first lightly doped layer in the epitaxial layer; forming a heavily doped layer in the first lightly doped layer; forming a second lightly doped layer in the first lightly doped layer; converting a portion of the second lightly doped layer into a metal silicide layer, wherein the top surface of the metal silicide layer is coplanar with the top surface of the gate structure; and disposing a metal layer to cover the metal silicide layer and the gate structure. Before converting the portion of the second lightly doped layer into the metal silicide layer, the doping concentration of the portion of the second lightly doped layer is less than the doping concentration of the heavily doped layer.

Optionally, in the preceding embodiment, the manufacturing method may further comprise: converting a portion of the heavily doped layer into the metal silicide layer, wherein converting the portion of the second lightly doped layer into the metal silicide layer and converting the portion of the heavily doped layer into the metal silicide layer are performed simultaneously, and ohmic contacts are formed respectively between the metal silicide layer and the second lightly doped layer, and between the metal silicide layer and the heavily doped layer.

Optionally, in any of the preceding applicable embodiments, the manufacturing method may further comprise: forming a barrier metal layer on the second lightly doped layer, wherein the step of converting the portion of the second lightly doped layer into the metal silicide layer comprising performing an annealing process on the barrier metal layer.

Optionally, in any of the preceding applicable embodiments, the metal layer directly contacts the barrier metal layer.

Optionally, in any of the preceding applicable embodiments, before the step of disposing the metal layer, the manufacturing method further comprises removing the barrier metal layer.

Optionally, in any of the preceding applicable embodiments, after the step of removing the barrier metal layer, the manufacturing method further comprises forming an additional metal layer on the metal silicide layer, wherein the metal layer is disposed on the additional metal layer.

Optionally, in any of the preceding applicable embodiments, the metal silicide layer includes the portion of the second lightly doped layer and a portion of the barrier metal layer, or includes a portion of the heavily doped layer and a portion of the barrier metal layer.

Optionally, in any of the preceding applicable embodiments, the barrier metal layer comprises cobalt, nickel, titanium or platinum.

Optionally, in any of the preceding applicable embodiments, the first lightly doped layer and the heavily doped layer have a P-type conductivity, and the epitaxial layer and the second lightly doped layer have a N-type conductivity.

Optionally, in any of the preceding applicable embodiments, the step of providing the gate structure comprises: forming a trench in the epitaxial layer; conformally forming a dielectric oxide layer in the trench; forming an electrode layer in the trench and surrounded by the dielectric oxide layer; and forming an isolation layer on the electrode layer and surrounded by the dielectric oxide layer.

Optionally, in any of the preceding applicable embodiments, a bottom surface of the second lightly doped layer is closer to the substrate than a bottom surface of the isolation layer.

Optionally, in any of the preceding applicable embodiments, a doping concentration of the second lightly doped layer at an interface between the second lightly doped layer and the metal silicide layer is less than 1E+18 cm⁻³.

Optionally, in any of the preceding applicable embodiments, before converting the portion of the second lightly doped layer into the metal silicide layer, the doping concentration of the portion of the second lightly doped layer is less than 1E+18 cm⁻³.

According to one aspect of the present disclosure, a semiconductor structure is provided that includes: an epitaxial layer on a substrate; a first lightly doped layer on the epitaxial layer; a second lightly doped layer on the first lightly doped layer; a heavily doped layer on the first lightly doped layer;a metal silicide layer on the second lightly doped layer and the heavily doped layer; and a gate structure, extending from a top surface of the metal silicide layer toward the substrate, through the second lightly doped layer, the heavily doped layer and the first lightly doped layer, and into the epitaxial layer.

Optionally, in any of the preceding applicable embodiments, the heavily doped layer adjoins the second lightly doped layer.

Optionally, in any of the preceding applicable embodiments, the second lightly doped layer and the heavily doped layer have different thicknesses.

Optionally, in any of the preceding applicable embodiments, a doping concentration of the second lightly doped layer at an interface between the second lightly doped layer and the metal silicide layer is less than a doping concentration of the heavily doped layer and greater than a doping concentration of the first lightly doped layer.

Optionally, in any of the preceding applicable embodiments, a doping concentration of the second lightly doped layer at an interface between the second lightly doped layer and the metal silicide layer is greater than a doping concentration of the second lightly doped layer at an interface between the second lightly doped layer and the first lightly doped layer.

Optionally, in any of the preceding applicable embodiments, the semiconductor structure further comprises a metal layer covering the metal silicide layer and the gate structure, wherein the second lightly doped layer, the heavily doped layer, the metal silicide layer and the metal layer are electrically connected to a source and serve as a source structure.

Optionally, in any of the preceding applicable embodiments, the gate structure comprises: an electrode layer; an isolation layer, disposed on the electrode layer; and a dielectric oxide layer surrounding the electrode layer and the isolation layer, wherein a top surface of the isolation layer and a top surface of the dielectric oxide layer are coplanar with the top surface of the metal silicide layer.

Optionally, in any of the preceding applicable embodiments, a bottom surface of the second lightly doped layer is closer to the substrate than a bottom surface of the isolation layer.

Optionally, in any of the preceding applicable embodiments, a thickness of the metal silicide layer is greater than or equal to 0.1 um.

Optionally, in any of the preceding applicable embodiments, the gate structure comprises: a first electrode layer; an isolation layer, disposed on the first electrode layer; a second electrode layer, disposed below the first electrode layer; and a dielectric oxide layer surrounding the first electrode layer, the second electrode layer and the isolation layer and extending between the first electrode layer and the second electrode layer, wherein a top surface of the isolation layer and a top surface of the dielectric oxide layer are coplanar with the top surface of the metal silicide layer.

According to another aspect of the present disclosure, a method is provided that includes: forming a gate structure in an epitaxial layer that is disposed on a substrate, the gate structure extending from a top surface of the epitaxial layer into the epitaxial layer; forming a first lightly doped layer in the epitaxial layer, the first lightly doped layer extending from the top surface of the epitaxial layer toward the substrate; forming a heavily doped layer in the first lightly doped layer; forming a second lightly doped layer in the first lightly doped layer; and forming a portion of the second lightly doped layer into a first portion of a metal silicide layer, a top surface of the metal silicide layer being coplanar with a top surface of the gate structure; and wherein before forming the portion of the second lightly doped layer into the first portion of the metal silicide layer, a doping concentration of the portion of the second lightly doped layer is less than a doping concentration of the heavily doped layer.

Optionally, in any of the preceding applicable embodiments, the method further comprises forming a portion of the heavily doped layer into a second portion of the metal silicide layer, wherein ohmic contacts are formed respectively between the metal silicide layer and the second lightly doped layer, and between the metal silicide layer and the heavily doped layer.

Optionally, in any of the preceding applicable embodiments, the method further comprises forming a barrier metal layer on the second lightly doped layer; wherein forming the portion of the second lightly doped layer into the first portion of the metal silicide layer comprises performing an annealing process on the barrier metal layer.

Optionally, in any of the preceding applicable embodiments, the method further comprises disposing a metal layer covering the metal silicide layer and the gate structure.

Optionally, in any of the preceding applicable embodiments, forming the gate structure comprises: forming a trench in the epitaxial layer, the trench recessed from the top surface of the epitaxial layer into the epitaxial layer; conformally forming a dielectric oxide layer in the trench; forming, in the trench, a first electrode layer surrounded by the dielectric oxide layer; and forming, in the trench, an isolation layer on the first electrode layer and surrounded by the dielectric oxide layer.

Optionally, in any of the preceding applicable embodiments, a bottom surface of the second lightly doped layer is closer to the substrate than a bottom surface of the isolation layer.

Optionally, in any of the preceding applicable embodiments, the method further comprises forming, in the trench, a second electrode layer below the first electrode layer and surrounded by the dielectric oxide layer, the second electrode layer being separated from the first electrode layer by the dielectric oxide layer.

Optionally, in any of the preceding applicable embodiments, a doping concentration of the second lightly doped layer at an interface between the second lightly doped layer and the metal silicide layer is less than 1E+18 cm⁻³.

According to another aspect of the present disclosure, a semiconductor structure is provided that includes: an epitaxial layer on a substrate; a first lightly doped layer on the epitaxial layer; a second lightly doped layer on the first lightly doped layer; a heavily doped layer on the first lightly doped layer, the second lightly doped layer adjoining the heavily doped layer, a top surface of the heavily doped layer being coplanar with a top surface of the second lightly doped layer, and the heavily doped layer having a thickness greater than the second lightly doped layer; a metal silicide layer on the second lightly doped layer and the heavily doped layer; and a gate structure, extending from a top surface of the metal silicide layer toward the substrate and into the epitaxial layer, the gate structure comprising: an electrode layer; an isolation layer, disposed on the electrode layer; and a dielectric oxide layer surrounding the electrode layer and the isolation layer, wherein a top surface of the isolation layer and a top surface of the dielectric oxide layer are coplanar with the top surface of the metal silicide layer; and wherein a doping concentration of the second lightly doped layer at an interface between the second lightly doped layer and the metal silicide layer is less than a doping concentration of the heavily doped layer.

Optionally, in any of the preceding applicable embodiments, the doping concentration of the second lightly doped layer at the interface between the second lightly doped layer and the metal silicide layer is greater than a doping concentration of the second lightly doped layer at an interface between the second lightly doped layer and the first lightly doped layer.

The foregoing has outlined rather broadly the features and technical advantages of the present disclosure in order that the detailed description of the disclosure that follows may be better understood. Additional features and advantages of the disclosure will be described hereinafter which form the subject of the claims of the disclosure. It should be appreciated by those skilled in the art that the conception and specific embodiment disclosed may be readily utilized as a basis for modifying or designing other structures or processes for carrying out the same purposes of the present disclosure. It should also be realized by those skilled in the art that such equivalent constructions do not depart from the spirit and scope of the disclosure as set forth in the appended claims.

### BRIEF DESCRIPTION OF THE DRAWINGS

Aspects of several embodiments of the present disclosure may be best understood when the following detailed description is read in conjunction with the accompanying drawings. It should be noted that various structures may not be drawn to scale. In fact, the dimensions of various structures may be arbitrarily enlarged or reduced for clarity of discussion.
FIG. 1 is a schematic perspective view of a semiconductor structure according to some embodiments of the present disclosure;
FIG. 2 is a top view of the semiconductor structure according to some embodiments of the present disclosure;
FIG. 3 is a cross-sectional view of the semiconductor structure according to some embodiments of the present disclosure;
FIG. 4 is a graph of doping concentrations of the semiconductor structure according to some embodiments of the present disclosure;
FIG. 5 to FIG. 19 are schematic diagrams of a semiconductor structure in various stages of manufacturing according to some embodiments of the present disclosure;
FIG. 20 is a schematic diagram of another semiconductor structure according to some embodiments of the present disclosure; and
FIG. 21 is a flowchart of a method of manufacturing a semiconductor structure according to embodiments of the present disclosure.

The same or similar components are marked with the same reference numerals in the drawings and detailed description. Several embodiments of the present disclosure will be readily understood from the following detailed description in conjunction with the accompanying drawings.

### DETAILED DESCRIPTION OF ILLUSTRATIVE EMBODIMENTS

The making and using of embodiments of this disclosure are discussed in detail below. It should be appreciated, however, that the concepts disclosed herein can be embodied in a wide variety of specific contexts, and that the specific embodiments discussed herein are merely illustrative and do not serve to limit the scope of the claims. Further, it should be understood that various changes, substitutions and alterations can be made herein without departing from the spirit and scope of this disclosure as defined by the appended claims.

Furthermore, one or more features from one or more of the following described embodiments may be combined to create alternative embodiments not explicitly described, and features suitable for such combinations are understood to be within the scope of this disclosure. It is therefore intended that the appended claims encompass any such modifications or embodiments.

The following disclosure provides various different embodiments or examples for implementing different features of the presented subject matter. Specific embodiments of components and configurations are described below. Certainly, these are examples only and are not intended to be limiting. In this disclosure, references to forming a first feature over or on a second feature may include embodiments where the first and second features are formed in direct contact, and may also include embodiments where an additional feature is formed between the first feature and the second feature such that the first feature and the second feature may not be in direct contact. In addition, the present disclosure may repeat reference signs and/or letters in various embodiments. Such repetition is for simplicity and clarity and does not in itself indicate relationships between the various embodiments and/or configurations discussed.

Embodiments of the present disclosure are discussed in detail below. It should be appreciated, however, that the present disclosure provides applicable concepts that can be embodied in a wide variety of specific contexts. The specific embodiments discussed herein are illustrative only, and do not limit the scope of the present disclosure.

Embodiments of the present disclosure provide a semiconductor structure and a method for manufacturing the same. The semiconductor structure uses a lightly doped layer to replace a heavily doped layer in a source structure, so that when the voltage changes instantaneously (for example, when a transistor is turned off), the effect of electron injection from the source is reduced, thereby suppressing the conduction of the parasitic bipolar transistor in the semiconductor structure and avoiding the conduction of unnecessary current. In addition, the semiconductor structure is further provided with a metal silicide layer between the lightly doped layer and the source electrode as an ohmic contact, and the thickness of the lightly doped layer is also reduced. Compared with general semiconductor structures, the semiconductor structure in the embodiments of the present disclosure effectively avoid the side effects caused by parasitic components.

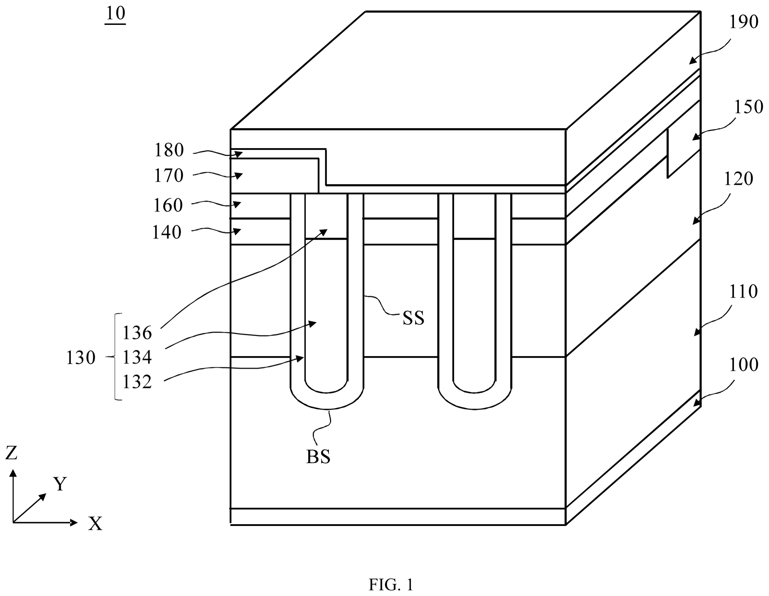

FIG. 1 is a schematic perspective view of a semiconductor structure 10 according to some embodiments of the present disclosure. The semiconductor structure 10 includes a substrate 100, an epitaxial layer 110, a first lightly doped layer 120, a second lightly doped layer 140, a metal silicide layer 160, a heavily doped layer 150, an interlayer dielectric oxide layer 170, and a metal layer 190. In this example, the epitaxial layer 110 is disposed on the substrate 100. The first lightly doped layer 120 is disposed on the epitaxial layer 110. The second lightly doped layer 140 and the heavily doped layer 150 are disposed on the first lightly doped layer 120. The metal silicide layer 160 is disposed on the second lightly doped layer 140 and the heavily doped layer 150. The metal layer 190 is disposed over the metal silicide layer 160. The interlayer dielectric oxide layer 170 is partially disposed between the metal silicide layer 160 and the metal layer 190.

The semiconductor structures of the embodiments of the present disclosure are described in X-direction, Y-direction and Z-direction as shown. The Z-direction is the vertical direction, i.e., in the top-bottom direction of the semiconductor structure 10. The Z-direction is perpendicular to a plane formed by the X-direction and the Y-direction. The X-direction is perpendicular to the Y-direction. The X-direction is in the width direction of the semiconductor structure 10. The Y-direction is in the length direction of the semiconductor structure 10. The plane formed by the X-direction and the Y-direction is in parallel to the top surface of the substrate 100.

In some embodiments, the substrate 100 may be disposed on the upper surface of a substrate adjacent to a silicon wafer or other semiconductor materials. In some embodiments, the substrate 100 is a portion of a silicon wafer. The material of the substrate 100 may include a single crystal silicon material, an epitaxial silicon material, silicon carbide (SiC), germanium (Ge), silicon germanium (SiGe), gallium nitride (GaN), gallium arsenide (GaAs), gallium arsenide phosphide (GaAsP) or other semiconductor materials.

In some embodiments, the epitaxial layer 110 may include, for example, a single crystal silicon material, an epitaxial silicon material, silicon carbide (SiC), germanium (Ge), silicon germanium (SiGe), gallium nitride (GaN), gallium arsenide (GaAs), gallium arsenide phosphide (GaAsP) or other semiconductor materials, which may be N-type or P-type. In some embodiments, the substrate 100 and the epitaxial layer 110 are N-type (a first conductivity type) epitaxial materials. For ease of explanation, N-type will be used as an example for the substrate 100 and the epitaxial layer 110, but the present disclosure is not limited thereto. The substrate 100 and the epitaxial layer 110 may be adjusted to be N-type (the first conductivity type) or P-type (a second conductivity type) according to requirements of the electrical properties of the semiconductor structure 10. In some embodiments, the doping concentration of the substrate 100 is greater than the doping concentration of the epitaxial layer 110.

In some embodiments, the first lightly doped layer 120 is of P-type (the second conductivity type), and the doping concentration of the first lightly doped layer 120 is greater than the doping concentration of the epitaxial layer 110. In some embodiments, the first lightly doped layer 120 serves as a doped body region of a transistor.

In some embodiments, the second lightly doped layer 140 is of N-type and the heavily doped layer 150 is of P-type. The doping concentration of the second lightly doped layer 140 is approximately greater than the doping concentration of the first lightly doped layer 120, and the doping concentration of the heavily doped layer 150 is approximately greater than the doping concentration of the second lightly doped layer 140.

In some embodiments, the metal material in the metal silicide layer 160 includes only a single metal. In some embodiments, the metal material in the metal silicide layer 160 includes a plurality of metals. In some embodiments, the material of the metal silicide layer 160 may include cobalt silicide (CoSix), nickel silicide (NiSix), titanium silicide (TiSix), platinum silicide (PtSix), or a combination thereof. The metal silicide layer 160 is in contact with the second lightly doped layer 140 and the heavily doped layer 150, and ohmic contacts are respectively formed between the metal silicide layer 160 and the second lightly doped layer 140 and between the metal silicide layer 160 and the heavily doped layer 150. In some embodiments, the metal silicide layer 160 has a substantially uniform thickness in the Z-direction.

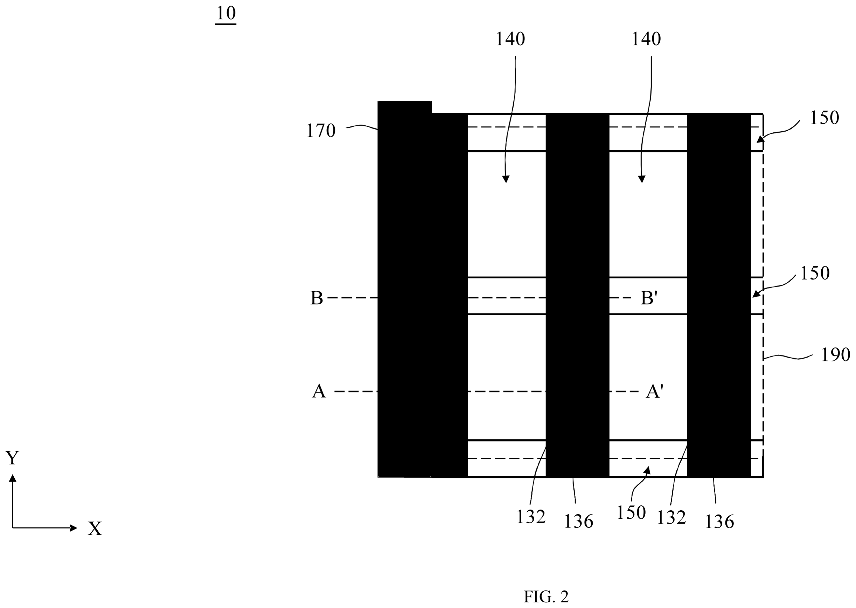

In some embodiments, the second lightly doped region 140 and the heavily doped layer 150 in combination covers the first lightly doped region 120. The top surface of the heavily doped layer 150 is coplanar with the top surface of the second lightly doped region 140. The second lightly doped region 140 may include multiple sub-regions 140, each of which extends in the X-direction, has a width in the Y-direction and a thickness in the Z-direction. The heavily doped layer 150 may include multiple sub-regions 150, each of which extends in the X-direction, has a width in the Y-direction and a thickness in the Z-direction. The sub-regions 140 and the sub-regions 150 may be disposed alternately along the Y-direction. This will be shown in FIG. 2.

In some embodiments, the thickness of the heavily doped layer 150 may be greater than the thickness of the second lightly doped region 140. In this case, the bottom surface of the heavily doped layer 150 is lower than the bottom surface of the second lightly doped region 140. That is, the bottom surface of the heavily doped layer 150 is closer to the substrate 100 than the bottom surface of the second lightly doped region 140.

The semiconductor structure 10 further includes a gate structure 130 and a source structure. The gate structure 130 extends from the top surface of the metal silicide layer 160 toward the substrate 100 and into the epitaxial layer 110. The second lightly doped layer 140, the heavily doped layer 150, the metal silicide layer 160 and the metal layer 190 are all electrically connected to a source (not shown) to serve as a source structure. That is, the second lightly doped layer 140, the heavily doped layer 150, the metal silicide layer 160 and the metal layer 190 form the source structure.

In some embodiments, the semiconductor structure 10 further includes a drain structure (not shown). The drain structure and the source structure are disposed on opposite sides of the gate structure 130, and the drain structure is electrically coupled to the substrate 100. The gate structure 130, the source structure, the drain structure and the doped body region together function as a transistor. In some embodiments, the drain structure and the source structure have similar structures.

In a top view of the semiconductor structure 10, the gate structure 130 extends along the Y-direction. On a plane defined by the X-direction and the Z-direction, the gate structure 130 has a trench profile. The gate structure 130 has sidewalls (or surfaces) SS and a bottom surface BS. The upper portion of the gate structure 130 is surrounded by the metal silicide layer 160. The gate structure 130 extends from the top surface of the metal silicide layer 160 toward the substrate 100, extends through the metal silicide layer 160, the second lightly doped layer 140, the heavily doped layer 150 and the first lightly doped layer 120, and partially extends into the epitaxial layer 110. In some embodiments, the gate structure 130 has a vertical sidewall SS and an arc-shaped bottom surface BS. The gate structure 130 includes an electrode layer 134, an isolation layer 136 and a dielectric oxide layer 132. The dielectric oxide layer 132 is conformally disposed on the sidewall SS and the bottom surface BS of the trench profile. The isolation layer 136 is disposed on the electrode layer 134, and the dielectric oxide layer 132 surrounds the electrode layer 134 and the isolation layer 136. There may be multiple gate structures 130 provided in the semiconductor structure 10, which may be disposed apart from each other along the X-direction.

In some embodiments, the interlayer dielectric oxide layer 170 may be disposed on the metal silicide layer 160 and cover a portion of the metal silicide layer 160. In some embodiments, the interlayer dielectric oxide layer 170 may extend in the Y-direction, and has a width in the X-direction and a thickness in the Z-direction. In some embodiments, the interlayer dielectric oxide layer 170 may cover a portion of the metal silicide layer 160, a portion of the gate structure 130, and a portion of the heavily doped region 150. In an example, the interlayer dielectric oxide layer 170 may be in a shape of a rectangular prism. Other shapes may also be applicable.

In some embodiments, the semiconductor structure 10 further includes a barrier metal layer 180 disposed between the metal silicide layer 160 and the metal layer 190. In some embodiments, the material of the barrier metal layer 180 may include cobalt (Co), nickel (Ni), titanium (Ti) or platinum (Pt). In some embodiments, the barrier metal layer 180 may be disposed on the interlayer dielectric oxide layer 170 and on the portion of the metal silicide layer 160 that is not covered by the interlayer dielectric oxide layer 170, and the metal layer 190 is disposed on the barrier metal layer 180. In other embodiments, the barrier metal layer 180 may be omitted. If the barrier metal layer 180 is not disposed, the metal layer 190 may be disposed on the interlayer dielectric oxide layer 170 and on the portion of the metal silicide layer 160 that is not covered by the interlayer dielectric oxide layer 170.

In some embodiments, the semiconductor structure 10 further includes an additional metal layer (not shown). The additional metal layer is disposed between the metal layer 190 and the metal silicide layer 160. The additional metal layer may be used to increase the current tolerance of the metal layer 190 and the metal silicide layer 160. In some embodiments, the additional metal layer includes titanium (Ti), aluminum (Al) and copper (Cu).

FIG. 2 is a top view of the semiconductor structure 10 according to some embodiments of the present disclosure. For ease of understanding, the top view of FIG. 2 illustrates a plane defined by the X-direction and the Y-direction, and omits the metal silicide layer 160 and the barrier metal layer 180. Specifically, FIG. 2 is a top view of the semiconductor structure 10, with the metal silicide layer 160, and the barrier metal layer 180 removed and the interlayer dielectric oxide layer 170 kept. FIG. 2 may also be understood as a cross-sectional view of the semiconductor structure 10 along the top surface of the second lightly doped layer 140, with the interlayer dielectric oxide layer 170 added on for illustration purposes.

Referring to FIG. 1 and FIG. 2, the gate structure 130 extends along the Y-direction and is surrounded by the second lightly doped layer 140 and the heavily doped layer 150. The second lightly doped layer 140 and the heavily doped layer 150 are adjacent and alternately arranged along the Y-direction. In other words, the heavily doped layer 150 and the second lightly doped layer 140 surround each other. It should be noted that the second lightly doped layer 140 and the heavily doped layer 150 do not overlap in a top view. As described above, the sub-regions 140 and sub-regions 150 are arranged on the first lightly doped layer 120 alternately along the Y-direction, and do not overlap. A sub-region 140 is disposed between two sub-regions 150, and adjoins the two sub-regions 150. It may also be understood as that a sub-region 140 is surrounded by sub-regions 150. A sub-region 150 is disposed between two sub-regions 140, and adjoins the two sub-regions 140. It may also be understood as that a sub-region 150 is surrounded by sub-regions 140.

The interlayer dielectric oxide layer 170 may partially cover the gate structure 130, the second lightly doped layer 140 and the heavily doped layer 150. That is, in the top view, the interlayer dielectric oxide layer 170 may cover a portion of the gate structure 130, a portion of the second lightly doped layer 140 and a portion of the heavily doped layer 150. In some embodiments, the interlayer dielectric oxide layer 170 may be used to define the region of the source structure. Specifically, the portion not covered by the interlayer dielectric oxide layer 170 may be used to form the metal layer 190 of the source structure, and the metal layer 190 may further extend to cover a portion of the interlayer dielectric oxide layer 170(the area covered by the metal layer 190 from the top view of the semiconductor structure 10 indicated by the dashed block in FIG. 2). The metal layer 190 may be disposed in the portion not covered by the interlayer dielectric oxide layer 170, or may be disposed above the interlayer dielectric oxide layer 170. That is to say, the metal layer 190 of the semiconductor structure 10 may be formed to cover the interlayer dielectric oxide layer 170, the metal silicide layer 160 and the gate structure(s) 130, or the metal layer 190 of the semiconductor structure 10 may be formed to cover the metal silicide layer 160 and the gate structure(s) 130 without covering the interlayer dielectric oxide layer 170.

It should be understood that the position and shape of the interlayer dielectric oxide layer 170 as shown are only for illustration purposes, and the present disclosure is not limited thereto. In other embodiments, the interlayer dielectric oxide layer 170 may have other suitable shapes and suitable arrangement.

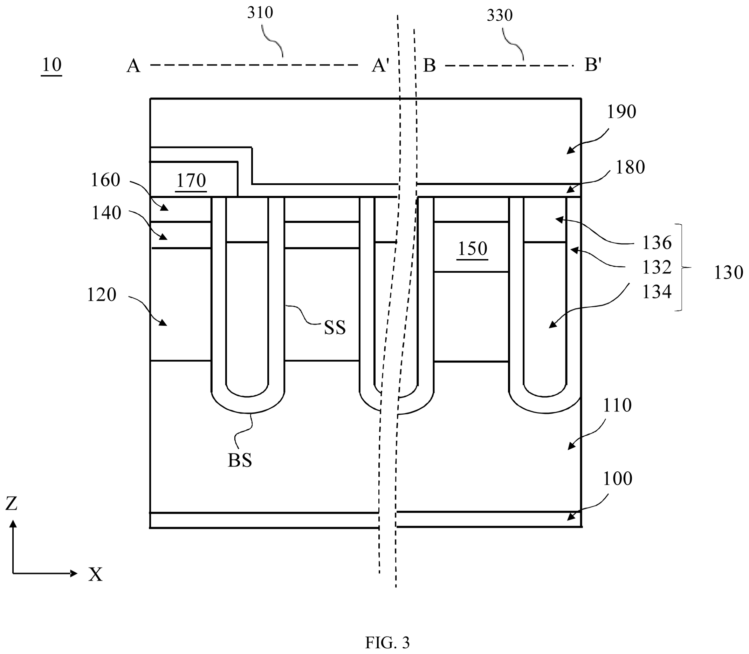

FIG. 3 is a side view of the semiconductor structure 10 according to some embodiments of the present disclosure. The side view of FIG. 3 depicts a plane defined by the X-direction and the Z-direction. For ease of understanding, the side view of FIG. 3 is divided into two parts, with the left and right sides of the side view separated by dashed hyperbolic lines, which respectively represent cross-sectional structures along a line segment AA' (including the second lightly doped layer 140) and a line segment BB' (including the heavily doped layer 150) in FIG. 2.

Specifically, FIG. 3 shows a portion 310 and a portion 330 of the semiconductor structure 10 separated by the dashed hyperbolic lines. The portion 310 may be understood as a cross-sectional view of the semiconductor structure 10 in FIG. 1 along the line segment AA' shown in FIG. 2. The portion 330 may be understood as a cross-sectional view of the semiconductor structure 10 in FIG. 1 along the line segment BB' shown in FIG. 2. The portions 310 and 330 are shown side by side in FIG. 3 merely for illustration convenience.

In the side view of FIG. 3, the top surface of the gate structure 130 is coplanar with the top surface of the metal silicide layer 160, and the top surface of the second lightly doped layer 140 is coplanar with the top surface of the heavily doped layer 150. More specifically, the top surface of the isolation layer 136, the top surface of the dielectric oxide layer 132 and the top surface of the metal silicide 160 are coplanar. The top surface of the electrode layer 134 is higher than the top surface of the first lightly doped layer 120 in the Z-direction, that is, the bottom surface of the second lightly doped layer 140 is closer to the substrate 100 than the bottom surface of the isolation layer 136. Further, as shown, in the Z-direction, the top surface of the electrode layer 134 is between the top surface and the bottom surface of the second lightly doped layer 140, and the bottom surface of the heavily doped region 150 is lower than the bottom surface of the second lightly doped layer 140.

In some embodiments, the metal silicide layer 160 has approximately the same thickness above the second lightly doped layer 140 and above the heavily doped layer 150 along the Z-direction. That is, the portion of the metal silicide layer 160 that is on the second lightly doped layer 140 has approximately the same thickness as the portion of the metal silicide layer 160 that is on heavily doped layer 150. In some embodiments, the second lightly doped layer 140 and the heavily doped layer 150 have different thicknesses. In some embodiments, the thickness of the second lightly doped layer 140 is less than the thickness of the heavily doped layer 150. In some embodiments, the thickness of the second lightly doped layer 140 is less than the thickness of the metal silicide layer 160. In some embodiments, the thickness of the metal silicide 160 is greater than or equal to 0.1 µm.

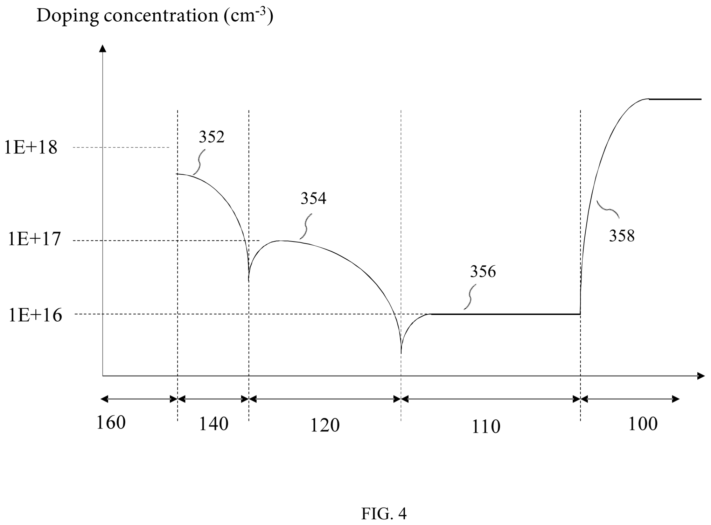

FIG. 4 is a schematic diagram of the doping concentration of the semiconductor structure 10 in the Z-direction according to some embodiments of the present disclosure. FIG. 4 illustrates doping concentrations from the second lightly doped layer 140, the first lightly doped layer 120, the epitaxial layer 110 to the substrate 100. FIG. 4 shows example doping concentrations of the second lightly doped layer 140 (a curve 352), the first lightly doped layer 120 (a curve 354), the epitaxial layer 110 (a curve 356) and the substrate 100 (a curve 358) varying along the Z-direction.

In the embodiment of FIG. 4, the second lightly doped layer 140, the epitaxial layer 110 and the substrate 100 are of N-type, and the first lightly doped layer 120 is of P-type. The peak value of the doping concentration of the second lightly doped layer 140 (i.e., the peak of the curve 352) is formed at the interface between the second lightly doped layer 140 and the metal silicide layer 160. In this example, the peak value of the doping concentration of the second lightly doped layer 140 is approximately between 1E+17 cm⁻³ and 1E+18 cm⁻³, which is higher than or equal to the peak value of the doping concentration of the first lightly doped layer 120 (i.e., the peak of the curve 354), but lower than the peak value of the doping concentration of the substrate 100 (i.e., the peak of the curve 358). In the present embodiment, the peak value of the doping concentration of the substrate 100 is approximately 1E+20 cm⁻³.

As shown in this example, the doping concentration of the second lightly doped layer 140 at the interface between the second lightly doped layer 140 and the metal silicide layer 160 is greater than the doping concentration of the second lightly doped layer 140 at the interface between the second lightly doped layer 140 and the first lightly doped layer 120. The doping concentration of the second lightly doped layer 140 gradually decreases from the interface between the second lightly doped layer 140 and the metal silicide layer 160 to the interface between the second lightly doped layer 140 and the first lightly doped layer 120. More specifically, the peak value of the doping concentration of the second lightly doped layer 140 is less than 1E+18 cm⁻³, and thus, the doping concentration of any part of the second lightly doped layer 140 is less than 1E+18 cm⁻³.

The doping concentration of the first lightly doped layer 120 at the interface between the second lightly doped layer 140 and the first lightly doped layer 120 is greater than the doping concentration of the first lightly doped layer 120 at the interface between the first lightly doped layer 120 and the epitaxial layer 110. The doping concentration of the first lightly doped layer 120 first rises to a peak value and then gradually decreases from the interface between the second lightly doped layer 140 and the first lightly doped layer 120 to the interface between the first lightly doped layer 120 and the epitaxial layer 110. As shown by the curve 354, the doping concentration of the first lightly doped layer 120 starts increasing from the interface between the second lightly doped layer 140 and the first lightly doped layer 120, reaches its peak at a certain position in the first lightly doped layer 120, and decreases from this position to the interface between the first lightly doped layer 120 and the epitaxial layer 110.

A depletion region is formed near the interface between the second lightly doped layer 140 and the first lightly doped layer 120 due to the contact of the N-type layer and the P-type layer, and thus, the doping concentration near the interface between the second lightly doped layer 140 and the first lightly doped layer 120 has a depression lower than that of the adjacent regions. That is, the doping concentration at the interface between the second lightly doped layer 140 and the first lightly doped layer 120 (where the curve 352 and the curve 354 connects) is lower than the doping concentrations of the second lightly doped layer 140 and the first lightly doped layer 120 adjacent to the interface. Similarly, the doping concentration near the interface between the first lightly doped layer 120 and the epitaxial layer 110 also has a depression lower than that of the adjacent regions.

Conventionally, the doping concentration of the N-type heavily doped layer of a source structure differs greatly from the doping concentration of the P-type doped body region, and thus, when the voltage changes instantaneously (for example, at the moment when a transistor is turned off), a strong electron injection effect is generated between the N-type heavily doped layer and the P-type doped body region, such that a parasitic bipolar transistor formed by the source structure, the doped body region and the epitaxial layer may be turned on. Compared with the conventional technology, the semiconductor structure 10 disclosed in the present disclosure uses the second lightly doped layer 140 to replace the N-type heavily doped layer in the source structure, thereby reducing the electron injection effect between the second lightly doped layer 140 and the first lightly doped layer 120, which reduces the chance of the parasitic bipolar transistor being turned on. Further, the semiconductor structure 10 of the present disclosure further converts a portion of the space in the original source structure, in which the N-type heavily doped layer is disposed, into the metal silicide layer 160, and the path of the current in the source structure passing through the second lightly doped layer 140 thus becomes shorter (the path along the Z - direction), which equivalently reduces the current impedance, and furthermore, the metal silicide layer 160 forms ohmic contacts with the second lightly doped layer 140 and the heavily doped layer 150. The performance of the semiconductor structure 10 of the present disclosure is improved in view of the technical effects brought up by the above structures. The semiconductor structure 10 as described in the above embodiments provides reduced electron injection effect between the second lightly doped layer 140 and the first lightly doped layer 120, forms ohmic contacts between the metal silicide layer 160 and the second lightly doped layer 140 and the heavily doped layer 150, and provide improved performance in the aspects discussed above compared with the conventional technology.

It should be understood that the doping concentrations shown in FIG. 4 are only for illustration and the present disclosure is not limited thereto. The doping concentrations may be set according to the requirements of the semiconductor structure 10, and various doping concentration distributions and changes are within the consideration and scope of the present disclosure. Specifically, the doping concentrations of the second lightly doped layer 140, the first lightly doped layer 120, the epitaxial layer 110 and the substrate 100, and the variations of the doping concentrations between these layers may be configured depending on specific applications and designs.

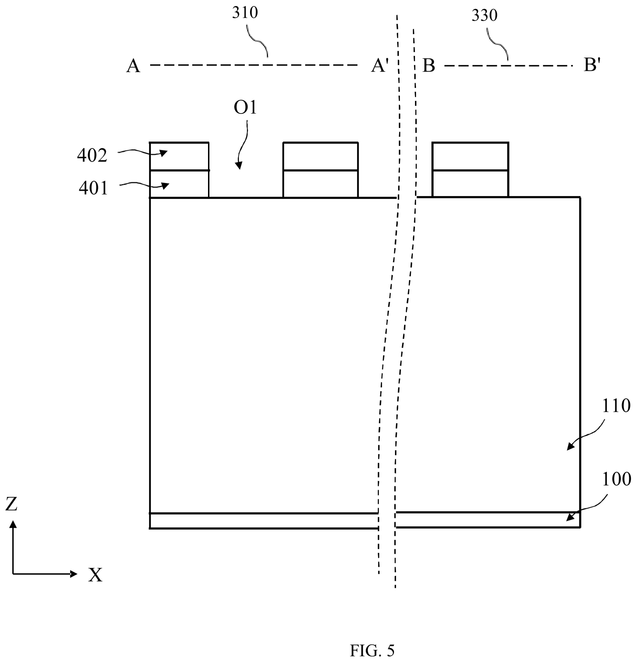

FIG. 5 to FIG. 19 are schematic diagrams of a manufacturing process of a semiconductor structure 10 according to some embodiments of the present disclosure. Specifically, FIG. 5 to FIG. 19 show the portions 310 and 330 of the semiconductor structure 10 in various stages of manufacture. The semiconductor structure 10 may be similar to that as described above with respect to FIG. 1 to FIG. 3.

Referring to FIG. 5, an epitaxial layer 110 is formed on a substrate 100. An oxide hard mask 401 may be formed on the epitaxial layer 110 using a thermal oxidation process. A patterned photoresist layer 402 may be formed on the oxide hard mask 401. The oxide hard mask 401 may be etched according to the patterned photoresist layer 402 to transfer the pattern on the photoresist layer 402 to the oxide hard mask 401. As shown in FIG. 5, after the pattern on the photoresist layer 402 is transferred to the oxide hard mask 401, a plurality of openings O1 are formed in the oxide hard mask 401. In some embodiments, after the pattern on the photoresist layer 402 is transferred to the oxide hard mask 401, the photoresist layer 402 is removed. The oxide hard mask 401 thus includes the openings O1 exposing a first portion of the epitaxial layer 100.

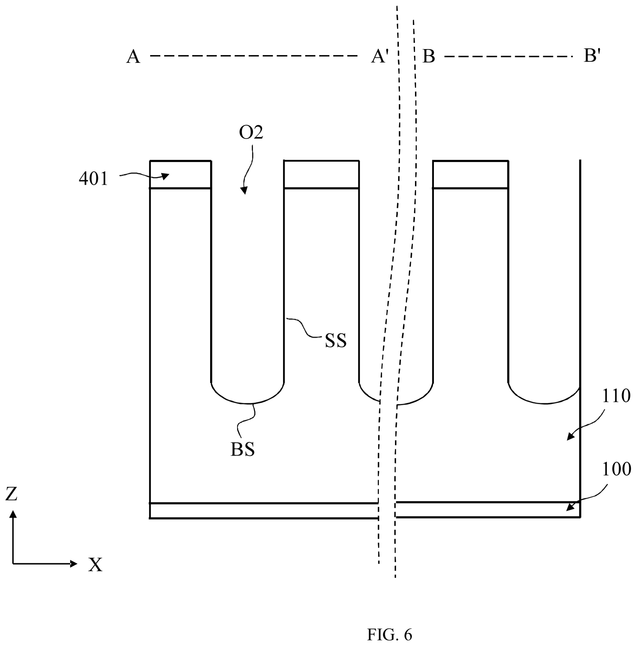

Referring to FIG. 6, corresponding to the openings O1 of the oxide hard mask 401, a plurality of openings O2 (which may also be referred to as trenches) extending toward the substrate 100 are formed in the epitaxial layer 110. Each opening O2 is formed according to a corresponding O1, and is recessed from the top surface of the exposed first portion of the epitaxial layer 100 into the epitaxial layer 100, without touching the substrate 100. Each opening O2 has opposing side surfaces SS and a bottom surface BS extending between the opposing side surfaces SS. The side surfaces of an opening and the bottom surface may be collectively referred to as an inner surface or an inner side surface of the opening in the present disclosure. After the plurality of openings O2 are formed, the oxide hard mask 401 is removed. After the oxide hard mask 401 is removed, the top surface of a second portion of the epitaxial layer 100 is exposed.

In some embodiments, after the oxide hard mask 401 is removed, a sacrificial oxide layer may be formed on the exposed surface of the epitaxial layer 110 by an oxidation process, and then the sacrificial oxide layer is removed. The exposed surface of the epitaxial layer 110 may include the top surface of the second portion of the epitaxial layer 100 that is exposed. The oxidation process may be performed by adding oxygen and heating to form an oxide, such as silicon dioxide, on the surface of the epitaxial layer 110. In some embodiments, the formation and removal of the sacrificial oxide layer is to optimize the surface of the epitaxial layer 110.

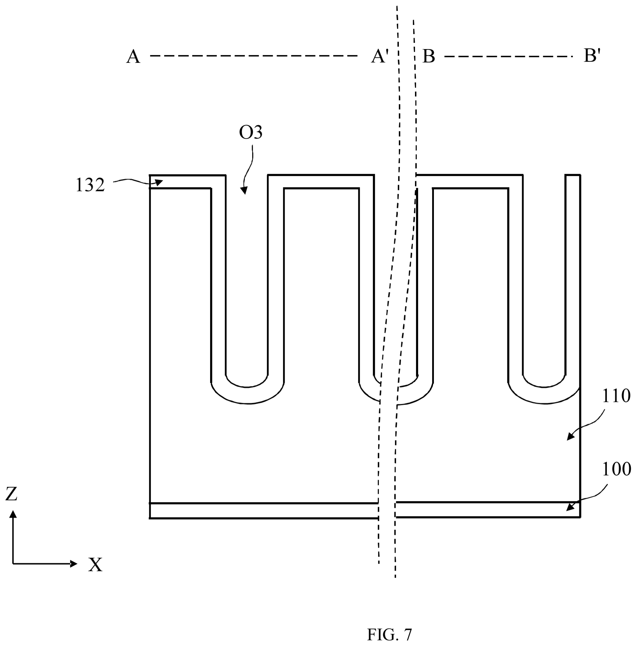

Referring to FIG. 7, a dielectric oxide layer 132 may be formed on the surface of the epitaxial layer 110. The surface of the epitaxial layer 110 includes the exposed top surface of the second portion of the epitaxial layer 100. The dielectric oxide layer 132 may also be formed on the inner surfaces of the openings O2, such that the openings O2 are reduced to become corresponding openings O3. In some embodiments, the thickness of the dielectric oxide layer 132 is substantially uniform. The dielectric oxide layer 132 may be formed on the exposed top surface of the second portion of the epitaxial layer 110 and on the inner surfaces of the openings O2, with a substantially uniform thickness.

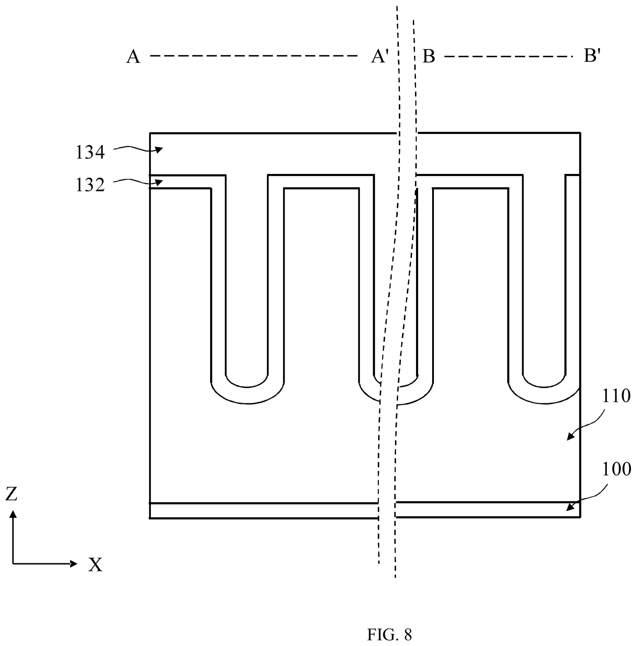

Referring to FIG. 8, an electrode layer 134 may be formed on the dielectric oxide layer 132 and fills the openings O3. In some embodiments, a planarization process may further be performed after the electrode layer 134 is formed so that the electrode layer 134 has a planar surface. The planarization process may be applied to planarize the top surface of the electrode layer 134.

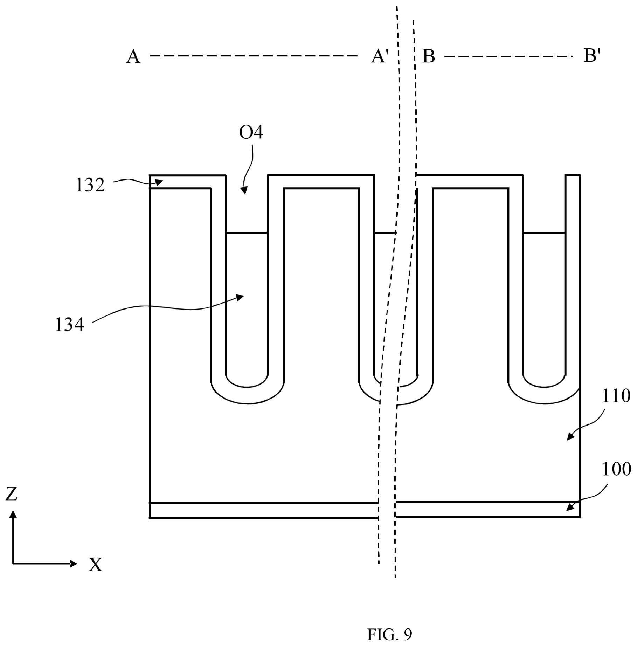

Referring to FIG. 9, an etching process is performed to remove a portion of the electrode layer 134, where the top surface of the remaining electrode layer 134 is lower than the top surface of the dielectric oxide layer 132, and the recessed electrode layer 134 forms a plurality of openings O4. In some embodiments, a portion of the electrode layer 134 that is outside the openings O3 are removed, exposing a portion of the dielectric oxide layer 132 that is formed on the top surface of the second portion of the epitaxial layer 110; and a portion of the electrode layer 134 in the openings O3 is partially removed, leaving the remaining electrode layer 134 in the openings O3. Partially removing the electrode layer 134 in the openings O3 exposes portions of the dielectric oxide layer 132 that are formed on the inner surfaces of the openings O2, resulting in the openings O4.

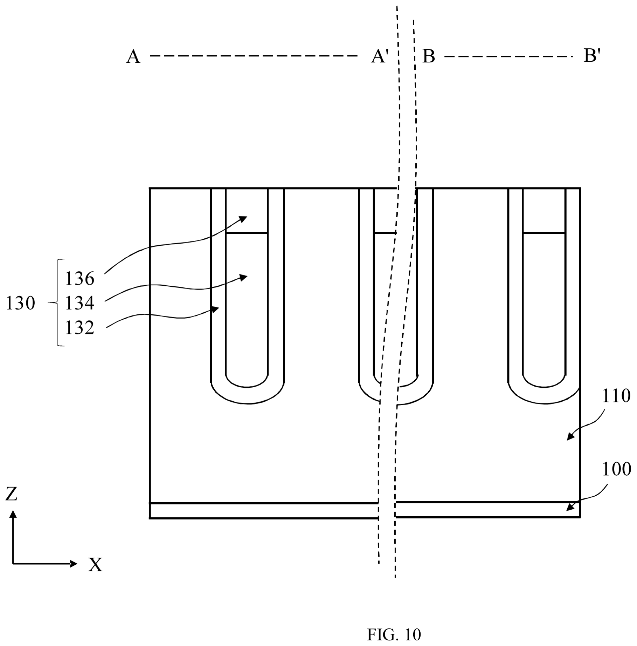

Referring to FIG. 10, an isolation layer 136 is deposited in the openings O4. In some embodiments, the isolation layer 136 may be simultaneously deposited on the top surface of the dielectric oxide layer 132. In some embodiments, the isolation layer 136 may be deposited on the dielectric oxide layer 132 that is outside the openings O4 and deposited to fill in the openings O4. After the isolation layer 136 is deposited, a planarization process may be performed to expose the top surface of the epitaxial layer 110. The planarization process removes the isolation layer 136 and the dielectric oxide layer 132 that are above the top surface of the epitaxial layer 110, exposing the top surface of the epitaxial layer 110 (specifically, the top surface of the second portion of the epitaxial layer 110). That is, the dielectric oxide layer 132 and the isolation layer 136 that are outside the openings O1 are removed. After the planarization process is performed, the top surface of the isolation layer 136 in the openings O4, the top surface of the dielectric oxide layer 132 in the openings O2, and the top surface of the epitaxial layer 110 are coplanar. The dielectric oxide layer 132, the electrode layer 134 and the isolation layer 136 in each opening O2 form a gate structure 130.

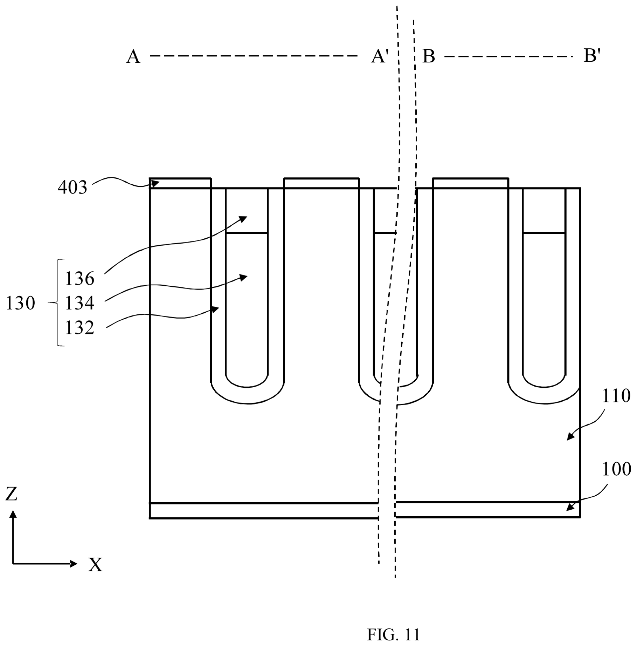

Referring to FIG. 11, a thermal oxidation process may be performed to form an oxide layer 403 on the top surface of the epitaxial layer 110. The oxide layer 403 is used as a pre-implantation oxide layer.

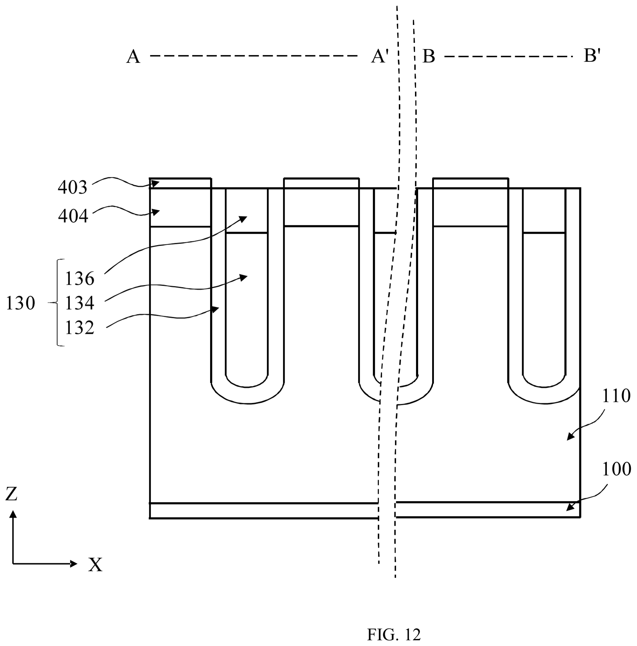

Referring to FIG. 12, an ion implantation process is performed on the epitaxial layer 110 to convert the upper portion of the epitaxial layer 110 into a doped layer 404. Before the ion implantation process is performed, a photoresist layer (not shown) may be deposited and patterned, and the patterned photoresist layer is used to define the range for forming the doped layer 404. The patterned photoresist layer may be applied on the semiconductor structure of FIG. 11 to serve as an ion implantation mask. Dopant is implanted into the upper portion of the epitaxial layer 110 to form the doped layer 404 by use of the ion implantation mask. After the ion implantation process is performed, the photoresist layer is removed.

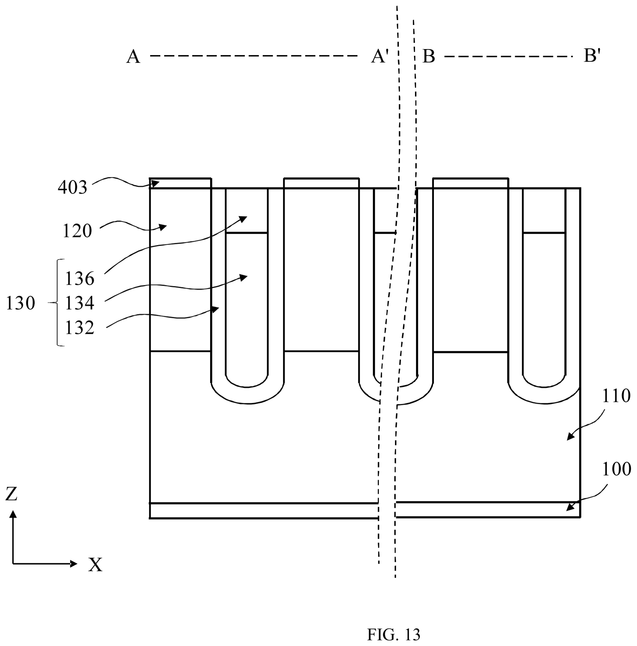

Referring to FIG. 13, a drive-in process may be performed to form a first lightly doped layer 120. Specifically, the dopant in the doped layer 404 is driven in a direction toward the substrate 100 along the -Z-direction, to transform the doped layer 404 into the first lightly doped layer 120. The bottom surface of the first lightly doped layer 120 is higher than the bottom surface of the dielectric oxide layer 132 in the Z-direction. In some embodiments, the bottom surface of the first lightly doped layer 120 may be higher than the bottom surface BS of the openings O2, and higher than the bottom surface of the electrode layer 134 in the openings O1.

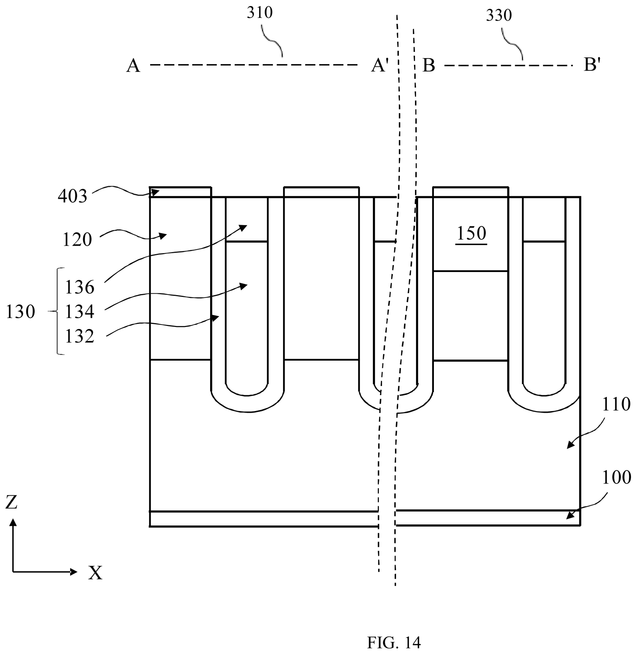

Referring to FIG. 14, an ion implantation process is performed on the first lightly doped layer 120, to convert the upper portion of the first lightly doped layer 120 in the cross-sectional structure along the line segment BB' into a heavily doped layer 150, where the first lightly doped layer 120 in the cross-sectional structure along the line AA' remains unchanged. The ion implantation process as described with respect to FIG. 14 is performed on the first lightly doped layer 120 that is in the portion 330, but not in the portion 310. The ion implantation process converts the upper portion of the first lightly doped layer 120 in the portion 330 into the heavily doped layer 150. The bottom surface of the heavily doped layer 150 may be lower than the bottom surface of the isolation 136 (or the upper surface of the electrode layer 134) in the openings O2 along the Z-direction. Before performing the ion implantation process, a photoresist layer (not shown) may be deposited and patterned, and the patterned photoresist layer is used to define the range for forming the heavily doped layer 150. The patterned photoresist layer is used as an ion implantation mask for performing the ion implantation process to form the heavily doped layer 150. After the ion implantation process is performed, the photoresist layer is removed. In some embodiments, after the heavily doped layer 150 is formed, a thermal annealing process may be performed on the heavily doped layer 150.

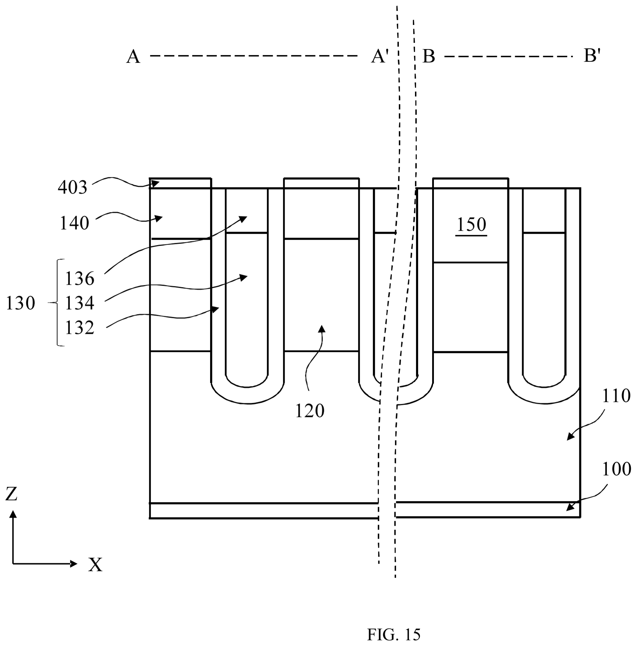

Referring to FIG. 15. An ion implantation process is performed on the first lightly doped layer 120 to convert the upper portion of the first lightly doped layer 120 in the cross-sectional structure along the line segment AA' into a second lightly doped layer 140. The ion implantation process as described with respect to FIG. 15 is performed on the first lightly doped layer 120 that is in the portion 310, but not in the portion 330. The ion implantation process converts the upper portion of the first lightly doped layer 120 in the portion 310 into the second lightly doped layer 140. The bottom surface of the second lightly doped layer 140 may be lower than the bottom surface of the isolation 136 (or the upper surface of the electrode layer 134) in the openings O2 along the Z-direction. The bottom surface of the second lightly doped layer 140 may be higher than or at the same level as the bottom surface of the heavily doped layer 150 along the Z-direction. Before performing the ion implantation process, a photoresist layer (not shown) may be deposited and patterned, and the patterned photoresist layer is used to define the range for forming the second lightly doped layer 140. The patterned photoresist layer is used as an ion implantation mask for performing the ion implantation process to form the second lightly doped layer 140. After performing the ion implantation process, the photoresist layer and the oxide layer 403 are removed. In some embodiments, after the second lightly doped layer 140 is formed, a thermal annealing process may be performed on the second lightly doped layer 140.

As shown in FIG. 15, the bottom surface of the second lightly doped layer 140 is closer to the substrate 100 than the bottom surface of the isolation layer 136. In other embodiments, the bottom surface of the second lightly doped layer 140 and the bottom surface of the isolation layer 136 may be at the same height in the Z-direction.

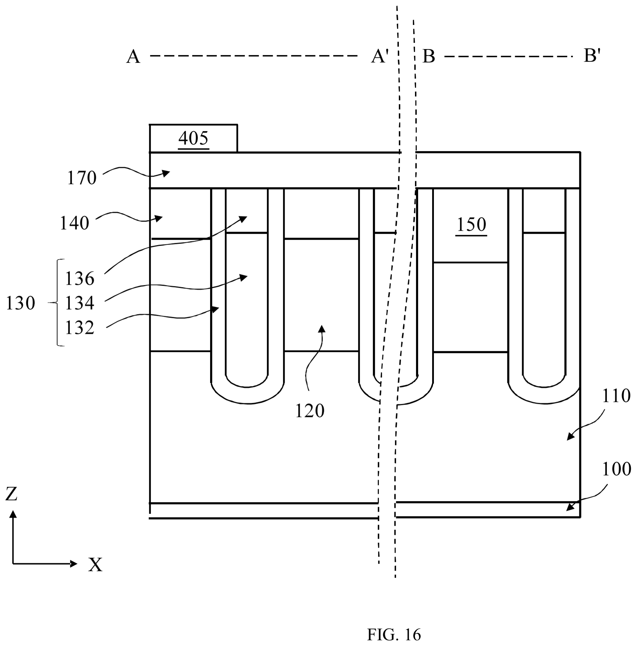

Referring to FIG. 16, an interlayer dielectric oxide layer 170 is formed to cover the structure shown in FIG. 15, and a patterned photoresist layer 405 is formed on the interlayer dielectric oxide layer 170. The interlayer dielectric oxide layer 170 may be formed on the top surface of the structure of FIG. 15, and specifically, formed on and covering the second lightly doped layer 140, the heavily doped layer 150, and the gate structure(s) 130. The patterned photoresist layer 405 formed on the interlayer dielectric oxide layer 170 may partially cover the interlayer dielectric oxide layer 170.

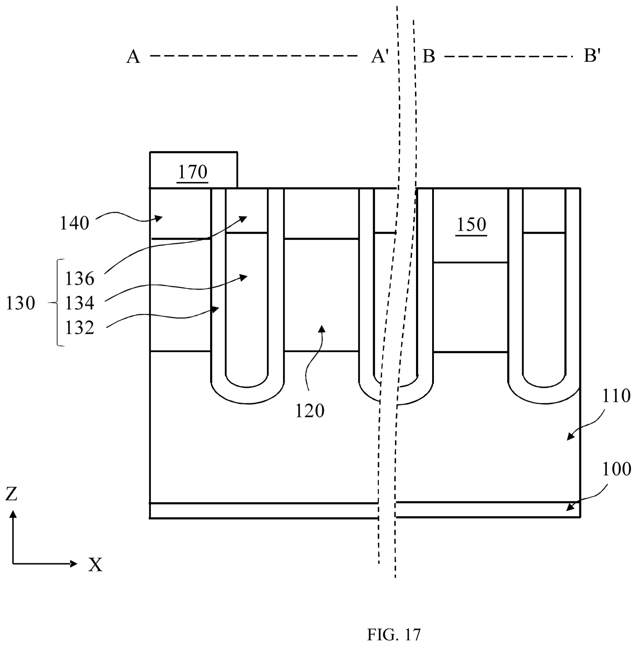

Referring to FIG. 17, an etching process may be performed to remove a portion of the interlayer dielectric oxide layer 170 according to the patterned photoresist layer 405. The portion of the interlayer dielectric oxide layer 170 not covered by the patterned photoresist layer 405 is removed. After the etching process is performed, the photoresist layer 405 is removed.

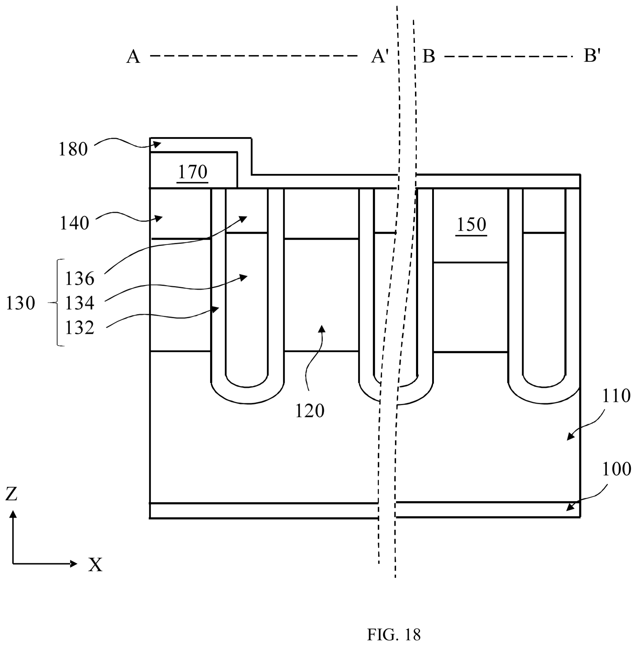

Referring to FIG. 18, a barrier metal layer 180 may be formed to cover the structure shown in FIG. 17. In some embodiments, the barrier metal layer 180 has a substantially uniform thickness. The barrier metal layer 180 may be formed on the top surface of the structure of FIG. 17, and specifically, formed on and covering the interlayer dielectric oxide layer 170, the second lightly doped layer 140, the heavily doped layer 150, and the gate structure(s) 130.

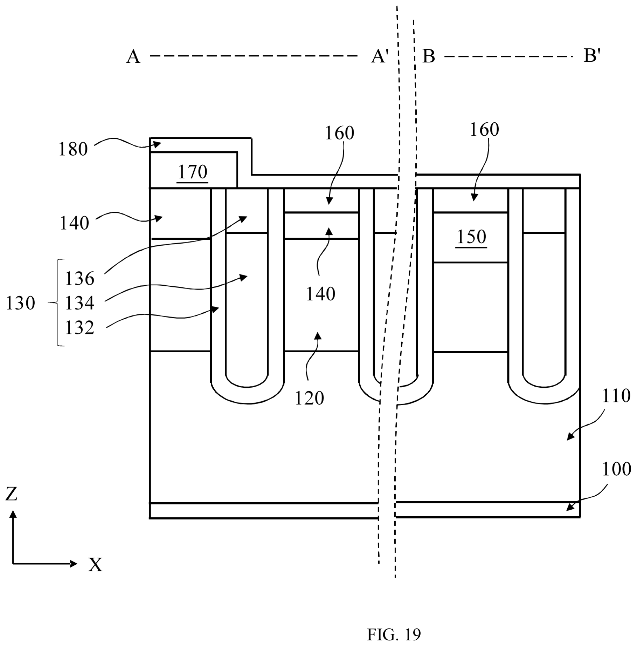

Referring to FIG. 19, an annealing process may be performed on the barrier metal layer 180 to form a metal silicide layer 160, and ohmic contacts are formed between the metal silicide layer 160 and the second lightly doped layer 140 and between the metal silicide layer 160 and the heavily doped layer 150. Specifically, the metal silicide layer 160 is formed in the upper portion of the second lightly doped layer 140, and in the upper portion of the heavily doped layer 150. When the annealing process is performed, because the upper portion of the second lightly doped layer 140 and the upper portion of the heavily doped layer 150 are in contact with the barrier metal layer 180, the metal atoms in the barrier metal layer 180 react with the second lightly doped layer 140 and the heavily doped layer 150, and as a result, the upper portion of the second lightly doped layer 140 and the upper portion of the heavily doped layer 150 are converted into the metal silicide layer 160. The metal silicide layer 160 on the second lightly doped layer 140 and the metal silicide layer 160 on the heavily doped layer 150 may be formed in the same annealing process. In other words, the metal silicide layer 160 on the second lightly doped layer 140 and the metal silicide layer 160 on the heavily doped layer 150 are formed simultaneously.

It should be noted that before forming the metal silicide layer 160, the doping concentration of any portion of the second lightly doped layer 140 is less than the doping concentration of the heavily doped layer 150. In some embodiments, before forming the metal silicide layer 160, the doping concentration of any portion of the second lightly doped layer 140 is less than 1E+18 cm⁻³.

After forming the metal silicide layer 160, a metal layer 190 may be formed to cover the structure shown in FIG. 19. A patterned photoresist layer may then be formed, and an etching process may be performed based on the patterned photoresist layer to remove a portion of the metal layer 190, to form the semiconductor structure 10 as described with respect to FIG. 1 to FIG. 3.

In some embodiments, before forming the metal layer 190, the barrier metal layer 180 may be removed, and thus, the resultant semiconductor structure 10 does not include the barrier metal layer 180.

In other embodiments, the semiconductor structure 10 further includes an additional metal layer (not shown) disposed on the metal silicide layer 160, and the metal layer 190 is disposed on the additional metal layer.

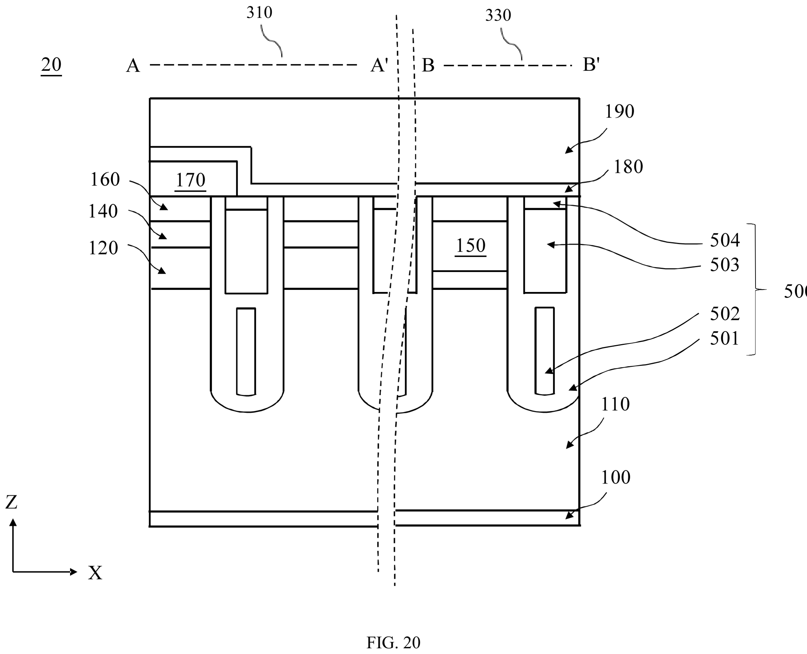

It is appreciated that the semiconductor structure 10 of the present disclosure is not limited to the above structures. For example, the gate structure 130 of the semiconductor structure 10 may be implemented with different structures, which is also within the scope of the present disclosure. FIG. 20 provides an example.

FIG. 20 is a schematic diagram of a semiconductor structure 20 according to embodiments of the present disclosure. For ease of understanding, the symbols in FIG. 20 follow the symbols in FIG. 1, FIG. 2 and FIG. 3, however, it does not mean that components using the same symbols must be the same.

The semiconductor structure 20 is substantially similar to the semiconductor structure 10, except for the gate structure. FIG. 20 shows the cross-sectional view of the semiconductor structure 20 including the portions 310 and 330, similar to the semiconductor structure 10 in FIG. 3. Specifically, the semiconductor structure 20 includes gate structure(s) 500. The gate structure 500 of the semiconductor structure 20 is arranged in the form of a split-gate. The gate structure 500 of the semiconductor structure 20 has two separate electrode layers, namely, an electrode layer 502 and an electrode layer 503, a dielectric oxide layer 501 and an isolation layer 504. The electrode layer 503 is arranged above the electrode layer 502, and the isolation layer 504 is arranged on the electrode layer 503. The dielectric oxide layer 501 surrounds the electrode layer 503, the electrode layer 502 and the isolation layer 504, and extends between the electrode layer 503 and the electrode layer 502. The top surface of the isolation layer 504, the top surface of the dielectric oxide layer 501 and the top surface of the metal silicide layer 160 are coplanar. In some embodiments, the electrode layer 503 may serve as part of the gate structure 500, and the electrode layer 502 may serve as part of the source structure. In this case, the electrode layer 502 may also be referred to as the source layer 502.

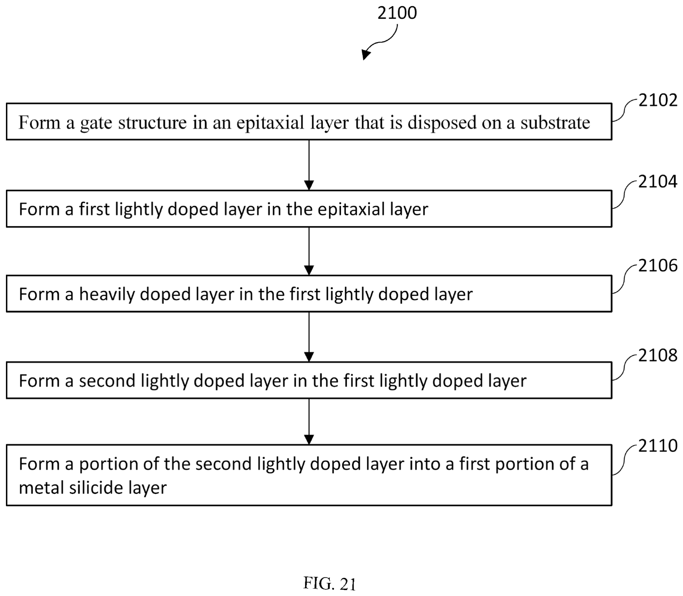

FIG. 21 is a flowchart of an example method 2100 of manufacturing a semiconductor structure according to embodiments of the present disclosure. The method 2100 may be representative of operations that may be performed to manufacture the semiconductor structure 10 or 20 as described above. It is appreciated that the order of performing some steps of the method 2100 may be changed, and some steps may be performed at the same time. Other applicable steps may also be added as described above in order to manufacture the semiconductor structure 10 or 20.

As shown, the method 2100 includes forming a gate structure in an epitaxial layer that is disposed on a substrate (block 2102). The gate structure may extend from a top surface of the epitaxial layer into the epitaxial layer. A first lightly doped layer may be formed in the epitaxial layer (block 2104). The first lightly doped layer may extend from the top surface of the epitaxial layer toward the substrate. A heavily doped layer may be formed in the first lightly doped layer (block 2106). A second lightly doped layer may be formed in the first lightly doped layer (block 2108). The method 2100 may further include forming a portion of the second lightly doped layer into a first portion of a metal silicide layer (block 2110). The top surface of the metal silicide layer may be coplanar with a top surface of the gate structure. In some embodiments, before forming the portion of the second lightly doped layer into the first portion of the metal silicide layer, a doping concentration of the portion of the second lightly doped layer is less than a doping concentration of the heavily doped layer. In some embodiments, a portion of the heavily doped layer may be formed into a second portion of the metal silicide layer. Ohmic contacts are formed respectively between the metal silicide layer and the second lightly doped layer, and between the metal silicide layer and the heavily doped layer.

The following provides further embodiments.

In an embodiment, a semiconductor structure is provided that includes: a substrate; an epitaxial layer on the substrate, a first lightly doped layer on the epitaxial layer, a second lightly doped layer on the epitaxial layer, and a metal silicide layer on the second lightly doped layer; a gate structure, extending from a top surface of the metal silicide layer toward the substrate and into the epitaxial layer; a heavily doped layer, disposed on the first lightly doped layer and surrounded by the second lightly doped layer; and a metal layer covering the top surface of the metal silicide layer, wherein the metal silicide layer covers and contacts a top surface of the second lightly doped layer and a top surface of the heavily doped layer, and wherein a doping concentration of the second lightly doped layer at an interface between the second lightly doped layer and the metal silicide layer is less than a doping concentration of the heavily doped layer and greater than a doping concentration of the first lightly doped layer.

Optionally, in the preceding embodiment, the heavily doped layer is disposed between the first lightly doped layer and the metal silicide layer, and adjoins the second lightly doped layer, and wherein in a top view, the heavily doped layer and the second lightly doped layer do not overlap.

Optionally, in any of the preceding applicable embodiments, the top surface of the second lightly doped layer is coplanar with the top surface of the heavily doped layer.

Optionally, in any of the preceding applicable embodiments, the second lightly doped layer and the heavily doped layer have different thicknesses.

Optionally, in any of the preceding applicable embodiments, a thickness of the second lightly doped layer is smaller than a thickness of the heavily doped layer.

Optionally, in any of the preceding applicable embodiments, the first lightly doped layer and the heavily doped layer have a P-type conductivity, and the epitaxial layer and the second lightly doped layer have a N- type conductivity.

Optionally, in any of the preceding applicable embodiments, at an interface between the second lightly doped layer and the metal silicide layer, a doping concentration of the second lightly doped layer is less than 1E+18 cm⁻³.

Optionally, in any of the preceding applicable embodiments, the doping concentration of the second lightly doped layer at the interface between the second lightly doped layer and the metal silicide layer is greater than a doping concentration of the second lightly doped layer at an interface between the second lightly doped layer and the first lightly doped layer.

Optionally, in any of the preceding applicable embodiments, the second lightly doped layer, the heavily doped layer, the metal silicide layer and the metal layer are all electrically connected to a source to serve as a source structure.

Optionally, in any of the preceding applicable embodiments, the gate structure may comprise: an electrode layer; an isolation layer, disposed on the electrode layer; and a dielectric oxide layer surrounding the electrode layer and the isolation layer, wherein a top surface of the isolation layer, a top surface of the dielectric oxide layer and a top surface of the metal silicide layer are coplanar.

Optionally, in any of the preceding applicable embodiments, a bottom surface of the second lightly doped layer is closer to the substrate than a bottom surface of the isolation layer.

Optionally, in any of the preceding applicable embodiments, a thickness of the second lightly doped layer is smaller than a thickness of the metal silicide layer.

Optionally, in any of the preceding applicable embodiments, the thickness of the metal silicide layer is greater than or equal to 0.1 um.

Optionally, in any of the preceding applicable embodiments, the metal silicide layer comprises cobalt silicide, nickel silicide, titanium silicide, platinum silicide, or a combination thereof.

Optionally, in any of the preceding applicable embodiments, the gate structure comprises: an electrode layer; an isolation layer, disposed on the electrode layer; a source layer, disposed below the electrode layer; and a dielectric oxide layer surrounding the electrode layer, the source layer and the isolation layer and extending between the electrode layer and the source layer, wherein a top surface of the isolation layer, a top surface of the dielectric oxide layer and a top surface of the metal silicide are coplanar.

Optionally, in any of the preceding applicable embodiments, ohmic contacts are formed between the metal silicide layer and the second lightly doped layer and between the metal silicide layer and the heavily doped layer, respectively.

Optionally, in any of the preceding applicable embodiments, the semiconductor structure may further comprise an additional metal layer disposed between the metal layer and the metal silicide layer, the additional metal layer comprising titanium, aluminum and copper.

In another embodiment, a manufacturing method of a semiconductor structure is provided that includes: providing a substrate, with an epitaxial layer on the substrate; disposing a gate structure in the epitaxial layer; forming a first lightly doped layer in the epitaxial layer; forming a heavily doped layer in the first lightly doped layer; forming a second lightly doped layer in the first lightly doped layer; converting a portion of the second lightly doped layer into a metal silicide layer, wherein a top surface of the metal silicide layer is coplanar with a top surface of the gate structure; and disposing a metal layer to cover the metal silicide layer and the gate structure, wherein before converting the portion of the second lightly doped layer into the metal silicide layer, a doping concentration of the portion of the second lightly doped layer is less than a doping concentration of the heavily doped layer.

Optionally, in the preceding embodiment, the manufacturing method may further comprise: converting a portion of the heavily doped layer into the metal silicide layer, wherein converting the portion of the second lightly doped layer into the metal silicide layer and converting the portion of the heavily doped layer into the metal silicide layer are performed simultaneously, and ohmic contacts are formed respectively between the metal silicide layer and the second lightly doped layer, and between the metal silicide layer and the heavily doped layer.

Optionally, in any of the preceding applicable embodiments, the manufacturing method may further comprise: forming a barrier metal layer on the second lightly doped layer, wherein the step of converting the portion of the second lightly doped layer into the metal silicide layer comprising performing an annealing process on the barrier metal layer.

Optionally, in any of the preceding applicable embodiments, the metal layer directly contacts the barrier metal layer.

Optionally, in any of the preceding applicable embodiments, before the step of disposing the metal layer, the manufacturing method further comprises removing the barrier metal layer.

Optionally, in any of the preceding applicable embodiments, after the step of removing the barrier metal layer, the manufacturing method further comprises forming an additional metal layer on the metal silicide layer, wherein the metal layer is disposed on the additional metal layer.

Optionally, in any of the preceding applicable embodiments, the metal silicide layer includes the portion of the second lightly doped layer and a portion of the barrier metal layer, or includes a portion of the heavily doped layer and a portion of the barrier metal layer.

Optionally, in any of the preceding applicable embodiments, the barrier metal layer comprises cobalt, nickel, titanium or platinum.

Optionally, in any of the preceding applicable embodiments, the first lightly doped layer and the heavily doped layer have a P-type conductivity, and the epitaxial layer and the second lightly doped layer have a N-type conductivity.

Optionally, in any of the preceding applicable embodiments, the step of providing the gate structure comprises: forming a trench in the epitaxial layer; conformally forming a dielectric oxide layer in the trench; forming an electrode layer in the trench and surrounded by the dielectric oxide layer; and forming an isolation layer on the electrode layer and surrounded by the dielectric oxide layer.

Optionally, in any of the preceding applicable embodiments, a bottom surface of the second lightly doped layer is closer to the substrate than a bottom surface of the isolation layer.

Optionally, in any of the preceding applicable embodiments, a doping concentration of the second lightly doped layer at an interface between the second lightly doped layer and the metal silicide layer is less than 1E+18 cm⁻³.

Optionally, in any of the preceding applicable embodiments, before converting the portion of the second lightly doped layer into the metal silicide layer, the doping concentration of the portion of the second lightly doped layer is less than 1E+18 cm⁻³.

In this disclosure, for description convenience, spatially relative terms such as "below", "under", "lower", "above", "upper", "left side", "right side", and so on, may be used to describe the relationship of one component or feature with another one or more components or features, as shown in the accompanying drawings. The spatially relative terms are not only used to depict the orientations in the accompanying drawings, but also intended to encompass different orientations of a device in use or operation. A device may be oriented in other ways (rotated 90 degrees or in other orientations), and the spatially relative terms used herein may be interpreted in a corresponding way similarly. It should be understood that when a component is referred to as being "connected to" or "coupled to" another component, it can be directly connected or coupled to another component or an intervening component may be present.

As used herein, the terms "approximately", "basically", "substantially" and "about" are used to describe and account for small variations. When used in conjunction with an event or instance, the terms may refer to an embodiment of exact occurrence of an event or instance as well as an embodiment where the event or instance is close to occurrence. As used herein with respect to a given value or range, the term "about" generally means being within ±10%, ±5%, ±1%, or ±0.5% of the given value or range. A range herein may be referred to as being from one endpoint to the other or as being between two endpoints. All ranges disclosed herein are inclusive of the endpoints unless otherwise indicated. The term "substantially coplanar" may mean that the difference of positions of two surfaces with reference to the same plane is within a few micrometers (µm), e.g., within 10 µm, within 5 µm, within 1 µm, or within 0.5 µm. When values or characteristics are referred to as being "substantially" the same, the term may refer to a value that is within ±10%, ±5%, ±1%, or ±0.5% of the mean of the values.

The foregoing has outlined features of some embodiments and detailed aspects of present disclosure. The embodiments described in the present disclosure may be readily used as a basis for designing or modifying other processes and structures in order to carry out the same or similar purposes and/or to achieve the same or similar advantages of the embodiments presented herein. Such equivalent constructions do not depart from the spirit and scope of the present disclosure, and various changes, substitutions, and alterations can be made without departing from the spirit and scope of the present disclosure.

Although the description has been described in detail, it should be understood that various changes, substitutions and alterations can be made without departing from the spirit and scope of this disclosure as defined by the appended claims. Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, which may perform substantially the same function or achieve substantially the same result as the corresponding embodiments described herein, may be utilized according to the present disclosure. Accordingly, the appended claims are intended to include within their scope such processes, machines, manufacture, compositions of matter, means, methods, or steps.

## Claims

1. A semiconductor structure comprising:
an epitaxial layer on a substrate;
a first lightly doped layer on the epitaxial layer;
a second lightly doped layer on the first lightly doped layer;
a heavily doped layer on the first lightly doped layer;
a metal silicide layer on the second lightly doped layer and the heavily doped layer; and
a gate structure, extending from a top surface of the metal silicide layer toward the substrate, through the second lightly doped layer, the heavily doped layer and the first lightly doped layer, and into the epitaxial layer.

2. The semiconductor structure of claim 1, wherein the heavily doped layer adjoins the second lightly doped layer.

3. The semiconductor structure of claim 1, wherein the second lightly doped layer and the heavily doped layer have different thicknesses.

4. The semiconductor structure of any one of preceding claims, wherein a doping concentration of the second lightly doped layer at an interface between the second lightly doped layer and the metal silicide layer is less than a doping concentration of the heavily doped layer and greater than a doping concentration of the first lightly doped layer.

5. The semiconductor structure of any one of preceding claims, wherein a doping concentration of the second lightly doped layer at an interface between the second lightly doped layer and the metal silicide layer is greater than a doping concentration of the second lightly doped layer at an interface between the second lightly doped layer and the first lightly doped layer.

6. The semiconductor structure of any one of preceding claims, further comprising a metal layer covering the metal silicide layer and the gate structure, wherein the second lightly doped layer, the heavily doped layer, the metal silicide layer and the metal layer are electrically connected to a source and serve as a source structure.

7. The semiconductor structure of any one of preceding claims, wherein the gate structure comprises:
an electrode layer;
an isolation layer, disposed on the electrode layer; and
a dielectric oxide layer surrounding the electrode layer and the isolation layer,
wherein a top surface of the isolation layer and a top surface of the dielectric oxide layer are coplanar with the top surface of the metal silicide layer, a bottom surface of the second lightly doped layer is closer to the substrate than a bottom surface of the isolation layer.

8. A method comprising:
forming a gate structure in an epitaxial layer that is disposed on a substrate, the gate structure extending from a top surface of the epitaxial layer into the epitaxial layer;
forming a first lightly doped layer in the epitaxial layer, the first lightly doped layer extending from the top surface of the epitaxial layer toward the substrate;
forming a heavily doped layer in the first lightly doped layer;
forming a second lightly doped layer in the first lightly doped layer; and
forming a portion of the second lightly doped layer into a first portion of a metal silicide layer, a top surface of the metal silicide layer being coplanar with a top surface of the gate structure; and
wherein before forming the portion of the second lightly doped layer into the first portion of the metal silicide layer, a doping concentration of the portion of the second lightly doped layer is less than a doping concentration of the heavily doped layer.

9. The method of claim 8, further comprising:
forming a portion of the heavily doped layer into a second portion of the metal silicide layer, wherein ohmic contacts are formed respectively between the metal silicide layer and the second lightly doped layer, and between the metal silicide layer and the heavily doped layer.

10. The method of claim 8 or 9, further comprising:
forming a barrier metal layer on the second lightly doped layer;
wherein forming the portion of the second lightly doped layer into the first portion of the metal silicide layer comprises performing an annealing process on the barrier metal layer.

11. The method of any one of claims 8 to 10, further comprising: disposing a metal layer covering the metal silicide layer and the gate structure.

12. The method of any one of claims 8 to 11, wherein forming the gate structure comprises:
forming a trench in the epitaxial layer, the trench recessed from the top surface of the epitaxial layer into the epitaxial layer;
conformally forming a dielectric oxide layer in the trench;
forming, in the trench, a first electrode layer surrounded by the dielectric oxide layer; and
forming, in the trench, an isolation layer on the first electrode layer and surrounded by the dielectric oxide layer.

13. The method of claim 12, wherein a bottom surface of the second lightly doped layer is closer to the substrate than a bottom surface of the isolation layer.

14. The method of claim 12 or 13, further comprising:
forming, in the trench, a second electrode layer below the first electrode layer and surrounded by the dielectric oxide layer, the second electrode layer being separated from the first electrode layer by the dielectric oxide layer.

15. The method of any one of claims 8 to 14, wherein a doping concentration of the second lightly doped layer at an interface between the second lightly doped layer and the metal silicide layer is less than 1E+18 cm⁻³.
